(19) Europäisches Patentamt

European Patent Office

Office européen des brevets

(11) **EP 0 564 076 B1**

(12) **EUROPEAN PATENT SPECIFICATION**

(45) Date of publication and mention
of the grant of the patent:
**22.05.2002 Bulletin 2002/21**

(51) Int Cl.[7]: **H01L 27/02**

(21) Application number: **93300848.4**

(22) Date of filing: **04.02.1993**

(54) **Electrostatic discharge protection**

Schutz gegen elektrostatische Entladungen

Protection contre des décharges électrostatiques

(84) Designated Contracting States:
**DE FR GB IT**

(30) Priority: **31.03.1992 KR 535292**

(43) Date of publication of application:
**06.10.1993 Bulletin 1993/40**

(73) Proprietor: **SAMSUNG ELECTRONICS CO., LTD.
Suwon-City, Kyounggi-Do 441-370 (KR)**

(72) Inventors:
• **Chin, Dae Je
Seoul (KR)**
• **Choi, Jong-Hyeon
Nowon-Ku, Seoul (KR)**

(74) Representative:
**Tunstall, Christopher Stephen et al
Harrison Goddard Foote,
Belgrave Hall
Belgrave Street
Leeds LS2 8DD (GB)**

(56) References cited:
**EP-A- 0 106 417          EP-A- 0 215 493
DE-A- 3 801 526          FR-A- 1 565 521
US-A- 4 691 217**

• **ELECTRICAL OVERSTRESS/ELECTROSTATIC
DISCHARGE SYMPOSIUM PROCEEDINGS
September 1991, LAS VEGAS, NEVADA, USA
pages 88 - 97 C. DUVVURY ET AL. 'A SYNTHESIS
OF ESD INPUT PROTECTION SCHEME'**
• **PATENT ABSTRACTS OF JAPAN vol. 6, no. 251
(E-147)10 December 1982 & JP-A-57 152 160
( MITSUBISHI ) 20 September 1982**
• **IEEE JOURNAL OF SOLID-STATE CIRCUITS vol.
SC-20, no. 2, April 1985, NEW YORK US pages
594 - 596 E. FUJISHIN ET AL. 'OPTMIZED ESD
PROTECTION CIRCUITS FOR HIGH-SPEED
MOS/VLSI'**
• **PATENT ABSTRACTS OF JAPAN vol. 2, no. 104
(E-53) 26 August 1978 & JP-A-53 069 589
( MITSUBISHI ) 21 June 1978**

**Description**

The present invention relates to circuits for protecting an internal circuit of a semiconductor device from electrostatic discharge (ESD) phenomena.

A semiconductor memory device is typically provided with a circuit for protecting the internal circuit of a chip from static electricity which is applied from the exterior of the chip. The protection circuit includes an ESD prevention element which is provided in an input pad of the chip. That is, punch-through phenomena occur in the ESD prevention element in the input pad of the chip to bypass high voltage current caused by electrostatic discharge to ground voltage terminal when static electricity is applied from the exterior of the chip. The physical mechanism of ESD phenomena and preventive measures therefor are specifically described in "Internal Chip ESD Phenomena Protection Circuit" disclosed in IEEE TRANSACTION ON ELECTRON DEVICES, PP.2133-2139, Vol.35, No.12, Dec. 1989. Also, our Patent Application GB 2 252 200 (corresponding to Korean Patent Application No. 91-1128) discloses means for preventing ESD between the input pad, source voltage and ground voltage, where an $n^+$ diffusion region separated by a field oxide layer is connected with the pad and ground voltage so that current caused by static electricity is bypassed to the ground voltage terminal when static electricity or ESD stress voltage is applied to the pad, and the technique of which is fundamentally realized by the punch-through phenomena of the $n^+$ diffusion region separated by the field oxide layer.

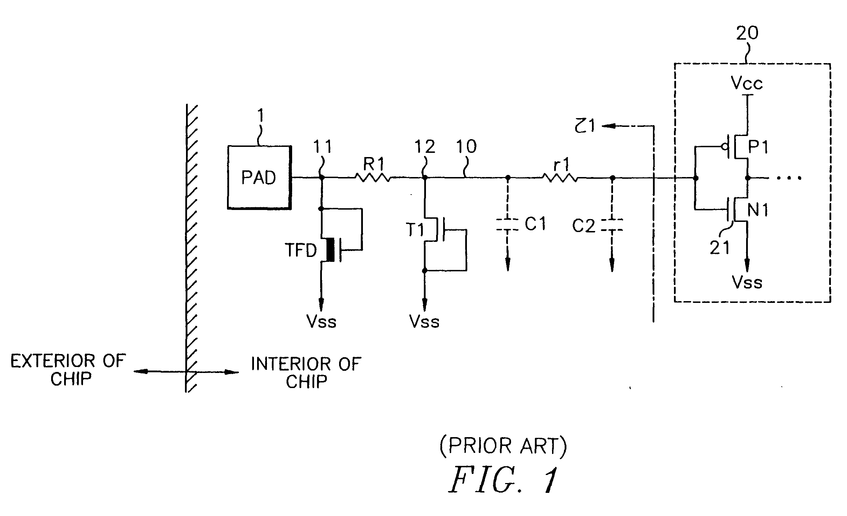

Referring to Figure 1 of the accompanying diagrammatic drawings, which shows an equivalent circuit of a conventional circuit for protecting an internal circuit from electrostatic discharge, an input pad 1 and internal circuit 20 are connected by a metal line 10. A TFD element for preventing ESD and MOS diode T1 used for a clamping circuit are connected in parallel between the metal line 10 and ground voltage Vss. There is also provided a resistor R1 consisting of an $n^+$ diffusion region between a node 11 connecting the metal line 10 with the TFD and a node 12 connecting the metal line 10 with the MOS diode T1. The resistor R1 has a high resistance value to protect a gate oxide layer 21 of an NMOS transistor N1 of the internal circuit 20 from an ESD stress voltage. When an ESD stress voltage is applied from the input pad 1 to the metal line 10 (about 3000V is used as a test voltage), the excessive current is instantly discharged through TFD and the excessive voltage which is dropped through the resistor R1 is applied to the internal circuit 20. Hence the ESD stress voltage is prevented from affecting the internal circuit 20.

However, such a conventional circuit for protecting the internal circuit from electrostatic discharge results in a long RC delay time $\tau1$ during the input signal transmission, which is caused by parasitic components induced between the node 12 and internal circuit 20, i.e. parasitic resistance r1 and capacitances c1 and c2. The RC delay time $\tau1$ may be expressed by Eq. 1.

$$\tau1 = R1{\cdot}c1 + (R1{+}r1){\cdot}c2 = R1{\cdot}(c1{+}c2) + r1{\cdot}c2 \qquad\text{(Eq. 1)}$$

If it is assumed that R1, r1, c1 and c2 are respectively 500Ω, 200Ω, 2pF and 2pF, then the RC delay time $\tau1$ becomes 2.4ns. The RC delay time increases with the values of the resistances and capacitances and the length of the metal line 10. In addition, if the RC delay time increases, the input signal transmission speed from the pad to the internal circuit is slowed down. Namely, an increase of the parametric values of the resistive components is needed to reduce the excessive ESD stress voltage, but this results in an excessive delay of the input signal transmission speed.

Preferred embodiments of the present invention aim to provide a method of protecting an internal circuit of a semiconductor device from electrostatic discharge that may reduce the RC delay time of an input signal.

According to one aspect of the present invention, there is provided a method of protecting an internal circuit of a semiconductor device from electrostatic discharge as defined in claim 1.

Further modifications are defined in claims 2-5.

Preferably, said resistor is connected with a gate of a MOS transistor provided in said internal circuit.

Preferably, said resistor comprises a diffusion region with a conductive material.

Preferably, another resistor and clamping device are cascaded between said ground voltage terminal and a node on said conduction line connecting said input pad and RC delay stage.

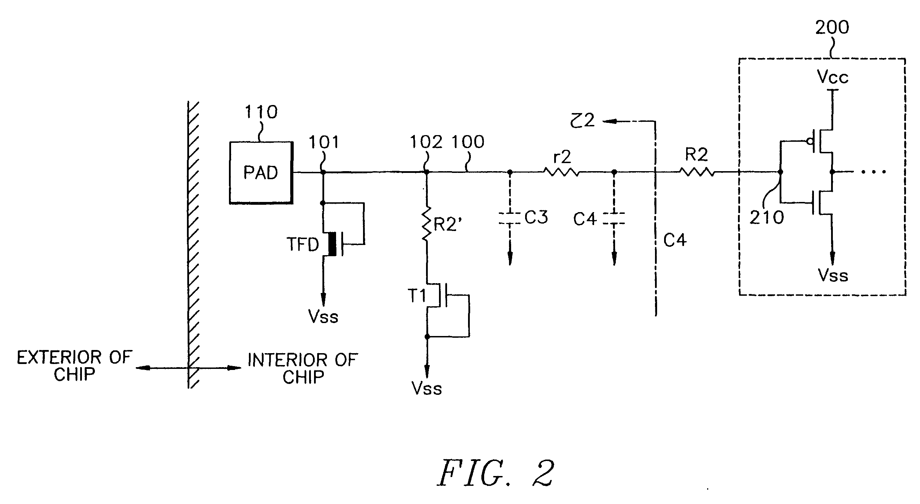

For a better understanding of the invention, and to show how the same may be carried into effect, reference will now be made, by way of example, to Figure 2 of the accompanying diagrammatic drawings, which is an equivalent circuit of a circuit for protecting an internal circuit of a semiconductor device from electrostatic discharge.

Referring to Figure 2, a metal line 100 connects an input pad 110 with an internal circuit 200. A TFD is connected between a node 101 and ground voltage Vss, and a resistor R2' and MOS diode T1 are cascaded between a node 102 and ground voltage Vss. The resistor R2' is employed to protect the MOS diode T1 used for a clamper circuit from an ESD stress voltage. The internal circuit 200 is, for example, an inverter which is generally employed in a CMOS integrated circuit. There also exist parasitic resistance r2 and capacitances c3 and c4 between the node 102 and internal circuit 200 of the metal line 100 . In addition, another resistor R2 is connected with an input terminal 210 of the internal circuit 200 in order to protect gate oxide layers of MOS transistors from the ESD stress voltage. The resistors R2' and R2 consist of n⁺ diffusion regions.

The resistor R2 for protecting the internal circuit 200 from the ESD stress voltage is connected between the RC delay stage which consists of the parasitic resistance r2 and capacitance c4 and the input terminal 210 of the internal circuit 200, so that the components which have a influence on the RC delay time are merely the parasitic resistance r2 and capacitance c4. Hence, the RC delay time $\tau2$ may be expressed by Eq. 2.

$$\tau2 = r2 \cdot c4 \qquad\qquad (Eq.\ 2)$$

If it is assumed that the values of the parasitic resistance r2 and capacitance c4 are 200Ω and 2pF respectively, then the RC delay time $\tau2$ becomes 0.4ns, which is reduced by 2ns compared to the RC delay time $\tau1(=2.4ns)$ of the conventional circuit of Figure 1. In the present embodiment, the values of the resistors R2' and R2 are set as 500Ω. If the values of the resistors R2' and R2 are set more than 500Ω in order to protect the gate oxide layer of the MOS transistor of the internal circuit 200 from greater ESD stress voltage, the RC delay time is not affected. Namely, according to this embodiment of the present invention, the RC delay time is determined only by the parasitic resistance and capacitance which are physically inherent in the metal line 100 connecting the input pad 110 and internal circuit 200. Of course, the parasitic resistance will be in proportion to the length of the metal line 100.

Thus the resistor for protecting the internal circuit from electrostatic discharge is arranged so as not to affect the RC delay time, and the input signal delay time is considerably reduced by the inventive circuit for protecting the internal circuit from electrostatic discharge.

The term "ground potential" (or like terms such as "ground voltage" or "earth" potential or voltage) is used conveniently in this specification to denote a reference potential. As will be understood by those skilled in the art, although such reference potential may typically be zero potential, it is not essential that it is so, and may be a reference potential other than zero.

The invention is not restricted to the details of the foregoing embodiment.

## Claims

1. A method of protecting an internal circuit (200) of a semiconductor device from electrostatic discharge comprising:

   connecting a first end of a conduction line (100) having between said first end and a second end an RC delay stage (r2, c4), directly to an input pad (110) for receiving an input signal to be applied to said internal circuit;
   connecting a punch-through element (TFD), for connecting said conduction line (100) with a ground voltage (Vss), directly to said conduction line between said input pad (110) and said RC delay stage (r2, c4);

   **characterized by:**

   determining that the RC delay time ($\tau2$) for the propagation of signals from the input pad to the second end of the conduction line when said second end of the conduction line is connected directly to said internal circuit (200) is the same as the RC delay time ($\tau2$) for the propagation of signals from the input pad to the second end of the conduction line when respective ends of a resistor R2 having a particular resistance value are connected directly to said second end of said conduction line and said internal circuit (200); and
   subsequently connecting respective ends of a resistor R2 having that particular resistance value directly to said second end of said conduction line and said internal circuit (200).

2. A method as defined in Claim 1, wherein said resistor (R2) has a value of 500Ω, and the values of said parasitic resistance and capacitance are 200Ω and 2pF, respectively.

3. A method as defined in Claim 1 or Claim 2, wherein said resistor (R2) is connected with a gate (210) of a MOS transistor provided in said internal circuit (200).

4. A method as defined in Claim 3, wherein said resistor (R2) comprises a diffusion region with a conductive material.

5. A method as defined in Claim 1, 2, 3 or 4, wherein another resistor (R2') and clamping device (T1) are cascaded between said ground voltage and a node (102) on said conduction line (100) connecting said input pad (110) and RC delay stage (r2, c3, c4).

**Patentansprüche**

1. Verfahren zum Schützen einer internen Schaltung (200) einer Halbleiter-Vorrichtung gegen elektrostatische Entladung, mit:

   Verbinden eines ersten Endes einer Leitungsbahn (100), die zwischen dem ersten Ende und einem zweiten Ende eine RC-Verzögerungsstufe (r2, c4) enthält, direkt mit einem Eingangsanschluß (110) zum Empfangen eines Eingangssignals, das der internen Schaltung zugeführt werden soll;
   Anschließen eines Durchgreifelements (TFD), um die Leitungsbahn (100) mit einer Erdspannung (Vss) zu verbinden, direkt an die Leitungsbahn zwischen dem Eingangsanschluß (110) und der RC-Verzögerungsstufe (r2, c4);

   **gekennzeichnet durch**:

   Bestimmen, daß die RC-Verzögerungszeit ($\tau$2) für die Fortpflanzung von Signalen von dem Eingangsanschluß zu dem zweiten Ende der Leitungsbahn, wenn das zweite Ende der Leitungsbahn direkt mit der internen Schaltung (200) verbunden ist, gleich der RC-Verzögerungszeit ($\tau$2) für die Fortpflanzung von Signalen von dem Eingangsanschluß zu dem zweiten Ende der Leitungsbahn ist, wenn jeweilige Enden von einem Widerstand (R2), der einen bestimmten Widerstandswert hat, direkt mit dem zweiten Ende der Leitungsbahn und der internen Schaltung (200) verbunden sind; und
   anschließendes Verbinden der jeweiligen Enden von einem Widerstand (R2), der diesen bestimmten Widerstandswert hat, direkt mit dem zweiten Ende der Leitungsbahn und der internen Schaltung (200).

2. Verfahren nach Anspruch 1, bei dem der Widerstand (R2) einen Wert von 500Ω hat und die Werte von dem parasitären Widerstand und Kapazität 200Ω bzw. 2pF betragen.

3. Verfahren nach Anspruch 1 oder Anspruch 2, bei dem der Widerstand (R2) mit einem Gate (201) eines MOS-Transistors verbunden ist, der in der internen Schaltung (200) vorgesehen ist.

4. Verfahren nach Anspruch 3, bei dem der Widerstand (R2) einen Diffusionsbereich mit einem konduktiven Material hat.

5. Verfahren nach Anspruch 1, 2, 3 oder 4, bei dem ein weiterer Widerstand (R2') und eine Klemmeinrichtung (T1) zwischen der Erdspannung und einem Knoten (102) an der Leitungsbahn (100) kaskadiert sind, die den Eingangsanschluß (110) und die RC-Verzögerungsstufe (r2, c3, c4) verbindet.

**Revendications**

1. Procédé de protection d'un circuit interne (200) d'un composant à semi-conducteur d'une décharge électrostatique comprenant :

   la connexion d'une première extrémité d'une ligne de conduction (100) ayant entre ladite première extrémité et une seconde extrémité un étage de retard RC (r2, c4), directement à un plot d'entrée (110) pour recevoir un signal d'entrée à appliquer audit circuit interne ;
   la connexion d'un élément de claquage (TFD), pour connecter ladite ligne de conduction (100) à une tension de masse (Vss), directement à ladite ligne de conduction entre ledit plot d'entrée (110) et ledit étage de retard RC (t2, c4) ;

   **caractérisé par** :

   la détermination que le temps de retard RC ($\tau$2) pour la propagation de signaux du plot d'entrée à la seconde extrémité de la ligne de conduction lorsque ladite seconde extrémité de la ligne de conduction est connectée directement audit circuit interne (200) est le même que le temps de retard RC ($\tau$2) pour la propagation de signaux du plot d'entrée à la seconde extrémité de la ligne de conduction lorsque des extrémités respectives d'une résistance R2 ayant une valeur de résistance particulière sont connectées directement à ladite seconde extrémité de ladite ligne de conduction et audit circuit interne (200) ; et
   ultérieurement, la connexion d'extrémités respectives d'une résistance R2 ayant cette valeur de résistance particulière directement à ladite seconde extrémité de ladite ligne de conduction et audit circuit interne (200).

2. Procédé tel que défini à la revendication 1, dans lequel ladite résistance (R2) a une valeur de 500 Ω et les valeurs desdites résistance et capacité parasites sont, respectivement, de 200 Ω et 2pF.

3. Procédé tel que défini à la revendication 1 ou à la revendication 2, dans lequel ladite résistance (R2) est connectée à une grille (210) d'un transistor MOS prévu dans ledit circuit interne (200).

4. Procédé tel que défini à la revendication 3, dans lequel ladite résistance (R2) comprend une région de diffusion avec un matériau conducteur.

5. Procédé tel que défini à la revendication 1, 2, 3 ou 4, dans lequel une autre résistance (R2') et un dispositif de fixation de niveau (T1) sont montés en cascade entre ladite tension de masse et un noeud (102) sur ladite ligne de conduction (100) connectant ledit plot d'entrée (110) et l'étage de retard RC (r2, c3, c4).

(PRIOR ART)
*FIG. 1*

FIG. 2

EP 0 564 076 B1